# FASCICULE DE BREVET EUROPEEN

(11) **EP 2 309 279 B1**
(45) Date de publication et mention de la délivrance du brevet: **09.05.2012**
(21) Numéro de dépôt: 10185816.5
(22) Date de dépôt: 01.10.2010
(51) Int. Cl.: G01R 31/00, G01R 31/02

(54) **Détection de court-circuit**
Kurzschluss-Erkennung
Short-circuit detection

(30) Priorité: 02.10.2009 FR 0956906
(43) Date de publication de la demande: 13.04.2011
(73) Titulaire: Airbus Operations, 31060 Toulouse (FR)
(72) Inventeur: Hopdjanian, Marie-Laure, 13012 Marseille (FR); Calvairac, Pierre, 31470 Fonsorbes (FR)
(74) Mandataire: Bonnans, Arnaud

(56) Documents cités:
- EP-A2- 2 090 893
- WO-A1-2006/136520
- DE-A1- 19 643 005
- FR-A1- 2 921 769
- US-A1- 2006 149 427
- US-A1- 2008 278 871

## Description

La présente invention concerne un élément de véhicule comportant des câbles électriques adaptés à transporter un courant électrique depuis au moins une génératrice, et notamment dans un aéronef.

On connaît déjà des aéronefs dont le réseau électrique comporte des génératrices électriques, notamment au niveau des ailes de l'aéronef à proximité des réacteurs, et un coeur électrique distribuant la puissance électrique délivrée par les génératrices, le coeur électrique étant situé dans le fuselage de l'aéronef.

Des câbles de phase s'étendent depuis chacune des génératrices jusqu'au coeur électrique en passant par le fuselage et/ou les ailes.

Afin de protéger l'aéronef contre un défaut de court-circuit dans l'un des câbles de phase, il est connu d'implémenter une fonction de protection différentielle.

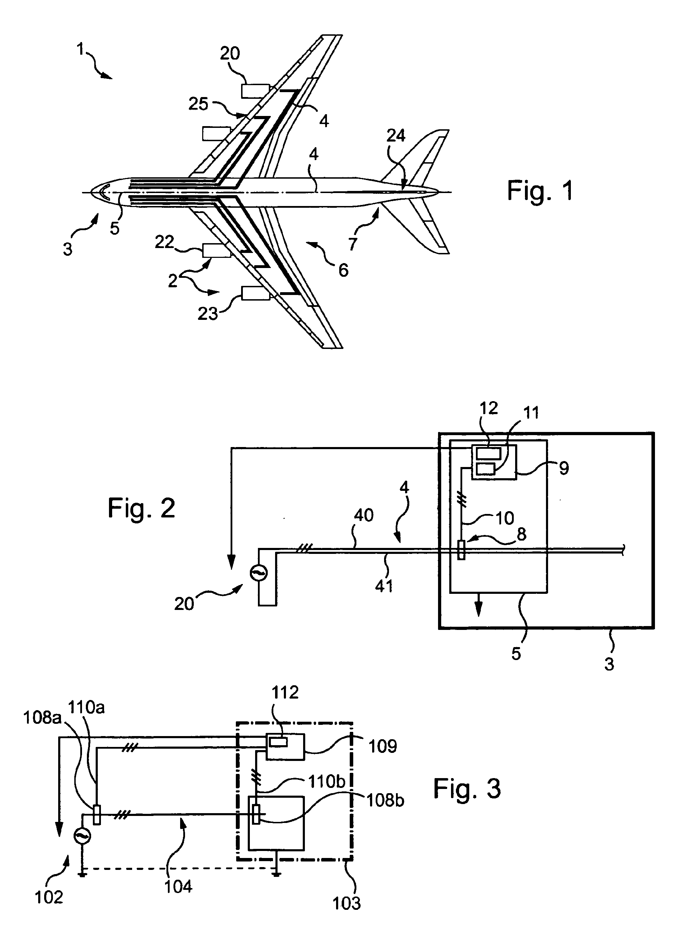

La figure 3 représente un tel dispositif de protection des câbles selon l'art antérieur, dans lequel on réalise une première mesure des courants circulant dans les trois câbles de phase 104, cette première mesure étant effectuée en sortie de chaque génératrice 102. Ces courants sont par exemple mesurés par des moyens 108a de mesure comportant au moins un transformateur de courant.

On réalise également une deuxième mesure des courants circulant dans les trois câbles de phase 104 à l'entrée du coeur électrique 103. Ces courants sont également mesurés par des moyens 108b de mesure comportant par exemple au moins un transformateur de courant.

Les premières et deuxièmes mesures de courant sont acheminées par des câbles de mesure de courant 110a, 110b vers une unité de commande et de calcul 109.

Le dispositif vérifie alors que la différence entre la mesure de courant au niveau de la génératrice et la mesure au niveau du coeur électrique n'excède pas une valeur limite (par exemple 50A pendant 50ms pour certains aéronefs) sur une des phases.

S'il n'y a pas de défaut, la différence entre les deux points de mesure pour chacun des câbles de phase est nulle.

S'il y a un défaut de court-circuit, la valeur limite est dépassée, et un module de commande 112 de la génératrice, présent dans l'unité 109, interrompt la génération de puissance par ladite génératrice.

De façon connue, c'est la structure métallique de l'aéronef qui assure la continuité du neutre électrique depuis la génératrice, reliée à la structure dans une nacelle, jusqu'au coeur électrique.

Un élément de véhicule comportant des câbles et un dispositif de protection comme évoqué précédemment présente l'inconvénient de nécessiter, puisque les appareils de mesure prennent deux mesures de courant pour un même câble en des points différents, des appareils de mesure parfaitement appariés afin d'avoir des réponses dynamiques identiques et n'induisant pas d'écart de mesure susceptible de déclencher la protection.

En outre, les câbles de mesure de courant nécessitent des routes dédiées et une analyse de risque particulière, puisqu'une rupture de ces câbles de mesure conduit au déclenchement de la protection et à la perte de la génératrice associée. Ces routes spécifiques sont difficiles à cheminer dans l'aéronef du fait de la densité élevée de câble électrique circulant dans l'aéronef, et notamment pour les câbles de mesure associés à la mesure effectuée en sortie de la génératrice, qui est effectuée à distance de l'unité de commande et de calcul et qui implique des chemins de câbles longs.

On connaît par ailleurs une conception de tels véhicules selon laquelle les structures métalliques sont remplacées par des structures en matériau composite. Dans ces structures, on envisage de câbler le neutre des génératrices jusqu'au coeur électrique sans passer par la structure, ce qui implique de prévoir un système de protection adapté à la présence de ce câble.

Le document EP 2 090 893 (Hamilton Sundstrand Corp.) divulgue un dispositif de détéction de défaut à la terre d'un aéronef.

L'invention vise à fournir un élément de véhicule comportant des câbles et un dispositif de détection de court-circuit qui soit particulièrement économique et simple à fabriquer.

Elle propose à cet effet un élément de véhicule comportant des câbles électriques adaptés à transporter un courant électrique depuis au moins une génératrice, avec lesdits câbles électriques qui comportent au moins un câble de phase associé à une phase de la génératrice, et comportant un dispositif de détection de court-circuit comportant des moyens de mesure adaptés à coopérer avec ledit câble de phase, caractérisé en ce que les câbles électriques comportent en outre un câble de neutre, le dispositif de détection comportant d'une part les moyens de mesure de courant, qui sont adaptés en outre à coopérer avec ledit câble de neutre, et d'autre part une unité de commande et de calculs reliée auxdits moyens de mesure de courant et adaptée à comparer à un seuil déterminé une valeur représentative de la résultante des courants circulant respectivement dans lesdits câbles électriques.

Dans l'élément de véhicule selon l'invention, le neutre de la génératrice est câblé et ce câble de neutre est utilisé par un dispositif de détection de court-circuit commun aux câbles de phase de cette génératrice

Le fait que le neutre soit câblé dans le véhicule permet de mesurer simultanément les valeurs de courant pour les trois phases et pour le neutre, et d'en déduire immédiatement si un courant de court-circuit est présent dans la structure du véhicule.

L'invention propose également un véhicule comportant un élément de véhicule tel que décrit ci-dessus et comportant un coeur électrique adapté à distribuer la puissance électrique reçue de ladite génératrice, avec le câble de phase et le câble de neutre qui s'étendent entre la génératrice et le coeur électrique, les moyens de mesure de courant étant reliés au câble de phase en un unique point de mesure le long dudit câble de phase, et au câble de neutre en un unique point de mesure le long dudit câble de neutre.

La mesure des courants en un unique point le long des câbles permet de diminuer le nombre de moyens de mesure de courant nécessaire, rendant ainsi le dispositif de détection particulièrement commode à installer et avantageux en termes de poids, de coût, et de fiabilité.

Selon une caractéristique de l'invention, les moyens de mesure de courant sont disposés dans le coeur électrique au voisinage de l'unité de commande et de calculs.

Le dispositif de détection est ainsi situé dans son ensemble dans le coeur électrique, et ne génère pas la présence de chemins de câble qui s'étendent dans le véhicule.

Selon une autre caractéristique de l'invention, les moyens de mesure de courant sont adaptés à mesurer individuellement le courant dans le câble de phase et dans le câble de neutre, l'unité de commande et de calculs étant adaptée à sommer les valeurs de courant mesurées et à comparer la somme obtenue audit seuil déterminé.

Ces mesures individuelles des courants circulant respectivement dans les câbles de phase permet de détecter les court circuits et permet en outre de détecter un éventuel défaut de sortie de la génératrice associée dans le cas d'une coupure totale des phases de la génératrice.

Selon d'autres caractéristiques de l'invention :
- le courant électrique transporté depuis la génératrice comporte trois phases, de sorte que les câbles électriques comportent trois câbles de phase et le câble de neutre, les moyens de mesure de courant étant reliés électriquement auxdits trois câbles de phase et audit câble de neutre, l'unité de commande et de calculs étant adaptée à comparer au seuil déterminé une valeur représentative de la résultante des quatre courants circulant respectivement dans lesdits câbles électriques ;
- les moyens de mesure de courant sont adaptés à mesurer individuellement le courant dans chacun des trois câbles de phase et dans le câble de neutre, l'unité de commande et de calculs étant adaptée à sommer les quatre valeurs de courant mesurées et à comparer la somme obtenue au seuil déterminé ;
- les moyens de mesure de courant comportent des transformateurs de courant, avec un transformateur de courant associé à chaque câble électrique ;
- la structure du véhicule est en matériau composite ; et
- le véhicule est un aéronef.

L'invention protège enfin un aéronef dont le coeur électrique, les moyens de mesure de courant et le calculateur de commande sont disposés dans la baie avionique, en pointe avant de l'aéronef.

Selon d'autres caractéristiques de l'invention :
- l'aéronef comporte des moyens de mesure de courant adaptés à coopérer avec les câbles électriques en amont dudit coeur électrique ; et/ou
- l'aéronef comporte au moins quatre génératrices disposées dans les ailes de l'aéronef et une génératrice auxiliaire dans le cône arrière du fuselage de l'aéronef, chaque génératrice étant reliée au coeur électrique par au moins un câble de phase et un câble de neutre, des moyens de mesure de courant étant associés à chaque générateur, et l'ensemble des moyens de mesure de courant étant reliés à l'unité de commande et de calcul.

L'exposé de l'invention sera maintenant poursuivi par la description détaillée d'exemples de réalisation, donnée ci après à titre illustratif et non limitatif, en référence aux dessins annexés, sur lesquels :
- la figure 1 est une représentation d'un aéronef comportant des câbles adaptés à relier des génératrices et un coeur électrique ;
- la figure 2 est un schéma représentatif de l'invention, dans lequel des câbles de phase et un câble de neutre s'étendent entre une génératrice et le coeur électrique du véhicule, avec des moyens de mesure qui sont reliés aux câbles de phase et au câble de neutre en un unique point de mesure le long de ces câbles ; et
- la figure 3 est un schéma représentatif de l'enseignement de l'état de la technique, dans lequel des câbles de phase et un câble de neutre s'étendent entre une génératrice et le coeur électrique du véhicule, avec des moyens de mesure qui sont disposés dans deux zones de mesures de courant.

Par la suite, on décrit un élément d'aéronef comportant des câbles et un dispositif de détection de court-circuit. Il sera compris que d'autres véhicules auraient pu être décrits comme un train, un véhicule automobile ou un bateau, sans sortir du contexte de l'invention, dès lors que l'on souhaite protéger les câbles d'un court-circuit dans un tel véhicule.

Comme illustré sur la figure 1, un aéronef 1 comporte des génératrices 2, un coeur électrique 3 et des câbles électriques 4 qui s'étendent entre chacune des génératrices 2 et le coeur 3. L'aéronef 1 comporte en outre un dispositif de détection de court-circuit 5 disposé dans le coeur électrique 3.

Ici, la structure de l'aéronef 1 est en matériau composite.

Les génératrices électriques 2 comportent quatre génératrices 20, 21, 22, 23 disposées au niveau des ailes 6 et entraînées par les moteurs, une génératrice 24 disposée dans le cône arrière 7 du fuselage et entraînée par une unité moteur auxiliaire (appelé APU), et ici une génératrice de secours 25 disposée également au niveau des ailes 6.

Ces génératrices 2 sont ici des génératrices à courant triphasé.

Le coeur électrique 3, adapté à distribuer la puissance électrique provenant des génératrices, est ici situé en pointe avant de l'aéronef, dans une zone communément appelée la baie avionique. Il sera compris que, sans sortir du contexte de l'invention, le coeur électrique peut être situé dans un tronçon central de l'aéronef.

Les câbles électriques 4 comportent des câbles de phase 40, ici au nombre de trois, et un câble de neutre 41, comme cela est visible sur la figure 2.

Les câbles de phase 40, associés respectivement à chacune des phases de chaque génératrice 2, s'étendent depuis les ailes 6, ou depuis le cône arrière 7, jusqu'au coeur électrique 3.

Le câble de neutre 41 relie le neutre de chaque génératrice 2 au neutre du coeur électrique 3.

On observera que, selon l'invention, le câble de neutre 40 est présent quelle que soit la structure de l'aéronef, notamment une structure métallique ou une structure, comme décrit précédemment, en matériau composite.

Comme illustré sur la figure 2, le dispositif de détection 5 comporte des moyens de mesure 8 et une unité de commande et de calculs 9. Un tel dispositif de détection 5 est prévu pour chaque ensemble de câbles électriques 4 comportant ici trois câbles de phase 40 et un câble neutre 41, et qui s'étend entre le coeur électrique 3 de l'aéronef et une des génératrices 2.

La description qui va suivre est effectuée pour un dispositif de détection associé à une génératrice 20 et aux câbles électriques qui relient cette génératrice 20 au coeur électrique 3, mais il sera compris que l'on peut prévoir avantageusement des dispositifs de détection semblables pour chacune des génératrices de l'aéronef.

Les moyens de mesure de courant 8 réalisent ici une mesure individuelle du courant dans chacun des trois câbles de phase 40 et du câble de neutre 41.

Comme cela est visible sur la figure 2, les moyens de mesure de courant 8 sont adaptés à coopérer avec les câbles de phase 40 et le câble de neutre 41, en un unique point de mesure le long de chacun de ces câbles entre la génératrice et le coeur électrique.

Les moyens 8 comportent ici des transformateurs de courant, avec un transformateur de courant associé à chaque câble.

Les moyens de mesure de courant 8 et l'unité de commande et de calculs 9 sont reliés par des câbles de mesure de courant 10, avec un câble de mesure de courant 10 associé à chaque câble de phase 40 et au câble de neutre 41.

On observera que selon l'invention, un seul câble de mesure 10 est associé à chaque câble électrique 4 du fait de la mesure en un unique point le long de chacun des câbles.

Les moyens de mesure de courant 8 et l'unité de commande et de calculs 9 sont disposés dans le coeur électrique, avec les moyens de mesure 8 qui sont au voisinage de l'unité 9. De la sorte, la longueur des câbles de mesure de courant 10 est ainsi réduite.

L'unité de commande et de calculs 9 comporte un module de calculs 11 et un module de commande 12.

Le module de calculs 11 reçoit, par l'intermédiaire des câbles de mesure de courant 10, une valeur représentative de la résultante des courants circulant dans les câbles.

Ici, dans l'exemple décrit d'une mesure individuelle des courants, le module de calculs 11 est programmé pour réaliser dans un premier temps la somme des valeurs de courant mesurées, chaque valeur pouvant être positive ou négative selon le sens de circulation de ces courants. Le module de calculs 11 compare dans un deuxième temps la somme obtenue à un seuil déterminé, pendant une durée fixée.

Sans défaut du circuit, la somme des quatre courants circulant dans les trois câbles de phase 40 et le câble de neutre 41 est en théorie nulle, donc inférieure au seuil déterminé. La valeur du seuil est déterminée pour que des oscillations minimes autour de cette valeur nulle théorique ne soient pas prises comme des défauts de court circuit.

S'il y a un défaut de court circuit qui vient s'ajouter aux quatre courants mesurés, la somme des courants excède le seuil déterminé pour la durée fixée.

Le module de calculs 11 compare ainsi la somme au seuil déterminé et transmet au module de commande 12 une information selon laquelle la ligne de câbles présente un défaut de court-circuit dès que la somme est supérieure au seuil déterminé pendant la durée fixée.

Le module de commande 12 est relié ici directement à la génératrice 20, de sorte qu'il peut générer, en réponse à une telle information de détection d'un court circuit dans la génératrice 20, une commande de cette génératrice pour l'isoler électriquement par exemple.

Ainsi selon l'invention, l'étude de la résultante des courants circulant respectivement dans les câbles et la mise en place de mesure de courant en un unique point le long de chaque câble électrique d'une génératrice donnée permet la détection d'un courant de court circuit et permet une intervention immédiate du module de commande sur la génératrice concernée. Cette détection de court circuit présente ainsi l'avantage de ne nécessiter qu'un nombre limité de moyens de mesure de courant et de câbles de mesure de courant, rendant ainsi le dispositif de détection particulièrement commode à installer, avec l'obtention d'un gain de masse dans le véhicule et d'un cout d'installation et d'entretien allégé. En outre, ce nombre limité de composant assure une fiabilité renforcée du dispositif de détection.

Selon d'autres variantes non représentées :
- le réseau n'est pas triphasé, mais monophasé : deux câbles seulement s'étendent entre chaque génératrice et le coeur électrique avec un câble de neutre et un câble de phase ; le principe de l'invention est le même avec les moyens de mesure de courant qui mesurent les valeurs du courant dans les deux câbles et l'unité de commande et de calcul qui vérifie que la somme des courants est sensiblement nulle ;
- le module de commande n'est pas relié directement à la génératrice, mais par l'intermédiaire d'un composant électrique qui transmet l'ordre d'alimentation fourni par le module de commande vers la génératrice ;
- les moyens de mesure de courant sont disposés en amont du coeur électrique ; et/ou
- les moyens de mesure de courant ne réalisent pas des mesures individuelles de chacun des trois câbles de phase et du câble de neutre ; les câbles de mesures du courant associés à chaque phase et au neutre sont enroulés autour d'un tore ; sans courant de court-circuit, la somme des courants circulants dans les câbles enroulés étant théoriquement nulle, il n'y a pas de flux magnétique résultant ; si les courants ne s'annulent pas, un champ magnétique est généré et cette information est transmise à l'unité de commande et de calcul qui compare la valeur de ce champ à un seuil.

On notera que, dans le cas d'une coupure totale sur les 3 phases, la somme des courants mesurés est nulle et qu'aucun courant de court-circuit n'est détecté ; une mesure individuelle des courants permet alors de repérer qu'il y a un défaut de sortie de l'une des génératrices.

On observera que selon l'invention, on a supprimé la mesure des courants en sortie de la génératrice, ce qui représente d'une part un gain du fait de la diminution du nombre des câbles et du nombre d'appareils de mesure à prévoir, et ce qui représente d'autre part un fonctionnement optimisé sans déclenchement intempestif du à une disparité de réglage des différents appareils de mesure pour un même génératrice.

Bien entendu, de nombreuses modifications peuvent être apportées à l'exemple de réalisation décrit précédemment sans sortir du cadre de l'invention.

## Revendications

1. Elément de véhicule comportant des câbles électriques (4) adaptés à transporter un courant électrique depuis au moins une génératrice (2), avec lesdits câbles électriques (4) qui comportent au moins un câble de phase (40) associé à une phase de la génératrice (2), et comportant un dispositif de détection de court-circuit (5) comportant des moyens de mesure (8) adaptés à coopérer avec ledit câble de phase (40), **caractérisé en ce que** les câbles électriques (4) comportent en outre un câble de neutre (41), le dispositif de détection (5) comportant d'une part les moyens de mesure de courant (8), qui sont adaptés en outre à coopérer avec ledit câble de neutre (41), et d'autre part une unité de commande et de calculs (9) reliée auxdits moyens de mesure de courant (8) et adaptée à comparer à un seuil déterminé une valeur représentative de la résultante des courants circulant respectivement dans lesdits câbles électriques (4).

2. Véhicule comportant un élément selon la revendication 1, **caractérisé en ce qu'**il comporte un coeur électrique (3) adapté à distribuer la puissance électrique reçue de ladite génératrice (2), avec le câble de phase (40) et le câble de neutre (41) qui s'étendent entre la génératrice (2) et le coeur électrique (3), les moyens de mesure de courant (8) étant reliés au câble de phase (40) en un unique point de mesure le long dudit câble de phase (40), et au câble de neutre (41) en un unique point de mesure le long dudit câble de neutre (41).

3. Véhicule selon la revendication 2, **caractérisé en ce que** les moyens de mesure de courant (8) sont disposés dans le coeur électrique (3) au voisinage de l'unité de commande et de calculs (9).

4. Véhicule selon l'une des revendications 2 ou 3, **caractérisé en ce que** les moyens de mesure de courant (8) sont adaptés à mesurer individuellement le courant dans le câble de phase (40) et dans le câble de neutre (41), l'unité de commande et de calculs (9) étant adaptée à sommer les valeurs de courant mesurées et à comparer la somme obtenue audit seuil déterminé.

5. Véhicule selon l'une des revendications 2 ou 3, **caractérisé en ce que** le courant électrique transporté depuis la génératrice (2) comporte trois phases, de sorte que les câbles électriques (4) comportent trois câbles de phase (40) et le câble de neutre (41), et que les moyens de mesure de courant (8) sont reliés électriquement auxdits trois câbles de phase (40) et audit câble de neutre (41), l'unité de commande et de calculs (9) étant adaptée à comparer au seuil déterminé une valeur représentative de la résultante des quatre courants circulant respectivement dans lesdits câbles électriques (4).

6. Véhicule selon la revendication précédente, **caractérisé en ce que** les moyens de mesure de courant (8) sont adaptés à mesurer individuellement le courant dans chacun des trois câbles de phase (40) et dans le câble de neutre (41), l'unité de commande et de calculs (9) étant adaptée à sommer les quatre valeurs de courant mesurées et à comparer la somme obtenue au seuil déterminé.

7. Véhicule selon la revendication 6, **caractérisé en ce que** les moyens de mesure de courant (8) comportent des transformateurs de courant, avec un transformateur de courant associé à chaque câble électrique (4).

8. Véhicule selon l'une des revendications 2 à 7, **caractérisé en ce que** la structure du véhicule est en matériau composite.

9. Véhicule selon l'une des revendications 2 à 8, **caractérisé en ce que** le véhicule est un aéronef.

10. Aéronef selon la revendication 9, **caractérisé en ce que** le coeur électrique (3), les moyens de mesure de courant (8) et l'unité de commande et de calculs (9) sont disposés dans la baie avionique, en pointe avant de l'aéronef.

## Claims

1. Vehicle part comprising electric cables (4) adapted for conveying an electric current from at least one generator (2), with the said electric cables (4) that comprise at least one phase cable (40) associated with a phase of the generator (2), and comprising a short-circuit detection device (5) comprising measurement means (8), adapted for cooperating with the said phase cable (40), **characterized in that** the electric cables (4) further comprise a neutral cable (41), the detection device (5) comprising on the one hand current measurement means (8), that are further adapted to cooperating with the said neutral cable (41), and on the other hand a control and calculations unit (9) connected to the said current measurement means (8) and adapted for comparing with a determined threshold a value representative of the resultant of the currents circulating respectively in the said electric cables (4).

2. Vehicle comprising a part according to claim 1, **characterized in that** it comprises an electric power center (3) adapted for distributing the electric power received from the said generator (2), with the phase cable (40) and the neutral cable (41) that extend between the generator (2) and the electric power center (3), the current measurement means (8) being connected to the phase cable (40) at a sole measurement point along the said phase cable (40), and to the neutral cable (41) at a sole measurement point along the said neutral cable (41).

3. Vehicle according to claim 2, **characterized in that** the current measurement means (8) are disposed in the electric power center (3) in the vicinity of the control and calculations unit (9).

4. Vehicle according to one of claims 2 or 3, **characterized in that** the current measurement means (8) are adapted for measuring individually the current in the phase cable (40) and in the neutral cable (41), the control and calculations unit (9) being adapted for adding the measured current values and for comparing the sum obtained with the said determined threshold.

5. Vehicle according to one of claim 2 or 3, **characterized in that** the electric current conveyed from the generator (2) comprises three phases, so that the electric cables (4) comprise three phase cables (40) and the neutral cable (41), and that the current measurement means (8) are connected electrically to the said three phase cables (40) and to the said neutral cable (41), the control and calculations unit (9) being adapted for comparing with the determined threshold a value representative of the resultant of the four currents circulating respectively in the said electric cables (4).

6. Vehicle according to the preceding claim, **characterized in that** the current measurement means (8) are adapted for measuring individually the current in each of the three phase cables (40) and in the neutral cable (41), the control and calculations unit (9) being adapted for adding the four measured current values and for comparing the sum obtained with the determined threshold.

7. Vehicle according to claim 6, **characterized in that** the current measurement means (8) comprise current transformers, with a current transformer associated with each electric cable (4).

8. Vehicle according to one of claims 2 to 7, **characterized in that** the structure of the vehicle is made of composite material.

9. Vehicle according to one of claims 2 to 8, **characterized in that** the vehicle is an aircraft.

10. Aircraft according to claim 9, **characterized in that** the electric power center (3), the current measurement means (8) and the control and calculations unit (9) are disposed in the avionic bay, in the forward cone of the aircraft.

## Patentansprüche

1. Fahrzeugteil mit Stromkabeln (4), die dazu geeignet sind, elektrischen Strom ausgehend von zumindest einem Stromerzeuger (2) über die Stromkabel (4) zu übertragen, die zumindest einen Phasenleiter (40) aufweisen, der einer Phase des Stromerzeugers (2) zugeordnet ist, und mit einer Vorrichtung (5) zum Erfassen eines Kurzschlusses, die Messmittel (8) aufweist, die dazu geeignet sind, mit dem Phasenleiter (40) zusammenzuwirken,
**dadurch gekennzeichnet, dass**
die Stromkabel (4) ferner einen Nullleiter (41) aufweisen, wobei die Erfassungsvorrichtung (5) einerseits die Messmittel (8) zum Messen des Stroms aufweist, die dazu geeignet sind, ferner mit dem Nullleiter (41) zusammenzuwirken, und andererseits eine Steuer- und Recheneinheit (9) enthält, die mit den Strommessmitteln (8) verbunden und dazu geeignet ist, einen Wert, der repräsentativ ist für die Resultierende aus den jeweiligen in den Stromkabeln (4) fließenden Strömen, mit einem bestimmten Schwellenwert zu vergleichen.

2. Fahrzeug mit einem Teil nach Anspruch 1,
**dadurch gekennzeichnet, dass**
es eine zentrale Stromversorgung (3) aufweist, die dazu geeignet ist, die von dem Stromerzeuger (2) erhaltene elektrische Leistung über den Phasenleiter (40) und den Nullleiter (41) abzugeben, die sich zwischen dem Stromerzeuger (2) und der zentralen Stromversorgung (3) erstrecken, wobei die Strommessmittel (8) mit dem Phasenleiter (40) in einem einzigen Messpunkt entlang des Phasenleiters (40) und mit dem Nullleiter (41) in einem einzigen Messpunkt entlang des Nullleiters (41) verbunden sind.

3. Fahrzeug nach Anspruch 2,
**dadurch gekennzeichnet, dass**
die Strommessmittel (8) in der zentralen Stromversorgung (3) benachbart zur Steuer- und Recheneinheit (9) angeordnet sind.

4. Fahrzeug nach einem der Ansprüche 2 oder 3,
**dadurch gekennzeichnet, dass**
die Strommessmittel (8) dazu geeignet sind, den Strom in dem Phasenleiter (40) und in dem Nullleiter (41) einzeln zu messen, wobei die Steuer- und Recheneinheit (9) dazu geeignet ist, die Strommesswerte zu summieren und die erhaltene Summe mit dem bestimmten Schwellenwert zu vergleichen.

5. Fahrzeug nach einem der Ansprüche 2 oder 3,
**dadurch gekennzeichnet, dass**
der ausgehend von dem Stromerzeuger (2) übertragene elektrische Strom drei Phasen enthält, so dass die Stromkabel (4) drei Phasenleiter (40) und den Nullleiter (41) enthalten, und dass die Strommessmittel (8) elektrisch mit den drei Phasenleitern (40) und mit dem Nullleiter (41) verbunden sind, wobei die Steuer- und Recheneinheit (9) dazu geeignet ist, einen Wert, der repräsentativ ist für die Resultierende aus den vier jeweiligen in den Stromkabeln (4) fließenden Strömen, mit dem bestimmten Schwellenwert zu vergleichen.

6. Fahrzeug nach dem vorangehenden Anspruch,
**dadurch gekennzeichnet, dass**
die Strommessmittel (8) dazu geeignet sind, den Strom in jedem der drei Phasenleiter (40) und in dem Nullleiter (41) einzeln zu messen, wobei die Steuer- und Recheneinheit (9) dazu geeignet ist, die vier Strommesswerte zu summieren und die erhaltene Summe mit dem bestimmten Schwellenwert zu vergleichen.

7. Fahrzeug nach Anspruch 6,
**dadurch gekennzeichnet, dass**
die Strommessmittel (8) Stromwandler aufweisen, wobei jedem Stromkabel (4) ein Stromwandler zugeordnet ist.

8. Fahrzeug nach einem der Ansprüche 2 bis 7,
**dadurch gekennzeichnet, dass**
der Aufbau des Fahrzeugs aus Verbundmaterial besteht.

9. Fahrzeug nach einem der Ansprüche 2 bis 8,
**dadurch gekennzeichnet, dass**
das Fahrzeug ein Luftfahrzeug ist.

10. Luftfahrzeug nach Anspruch 9,
**dadurch gekennzeichnet, dass**
die zentrale Stromversorgung (3), die Strommessmittel (8) und die Steuer- und Recheneinheit (9) in dem Avionik-Modul in der vorderen Spitze des Luftfahrzeugs angeordnet sind.
